# EUROPEAN PATENT APPLICATION

(11) **EP 4 435 537 A1**
(43) Date of publication of application: **25.09.2024**
(21) Application number: 24161107.8
(22) Date of filing: 04.03.2024
(51) Int. Cl.: G05B 17/02

(54) **SUBSTRATE PROCESSING APPARATUS, METHOD OF MANUFACTURING SEMICONDUCTOR DEVICE, AND PROGRAM**

(30) Priority: 20.03.2023 JP 2023044497; 31.08.2023 JP 2023141452
(71) Applicant: Kokusai Electric Corporation, Tokyo 101-0045 (JP)
(72) Inventor: TAKATA, Kyo, Toyama-shi, Toyama 939-2393 (JP); MITSUI, Hiroyuki, Toyama-shi, Toyama 939-2393 (JP); EKKO, Hiroshi, Toyama-shi, Toyama 939-2393 (JP); MORI, Shinichiro, Toyama-shi, Toyama 939-2393 (JP); YAMAOKA, Yuji, Toyama-shi, Toyama 939-2393 (JP)
(74) Representative: Bardehle Pagenberg Partnerschaft mbB Patentanwälte Rechtsanwälte

(57) **Abstract**

There is provided a technique that includes: a substrate processor configured to process a substrate according to a recipe including at least one step defining a substrate processing condition; an operator configured to receive an editing operation for at least one setting item included in the substrate processing condition; a calculator configured to calculate a control value for a setting value of the at least one setting item in conformity with an edited substrate processing condition obtained by the editing operation; and a controller configured to be capable of controlling a displayer to display time-series data of the control value calculated by the calculator together with information about the at least one step.

## Description

### CROSS-REFERENCE TO RELATED APPLICATION

This application is based upon and claims the benefit of priority from Japanese Patent Application No. 2023-044497, filed on March 20, 2023, and Japanese Patent Application No. 2023-141452, August 31, 2023, the entire contents of which are incorporated herein by reference.

### TECHNICAL FIELD

The present disclosure relates to a substrate processing apparatus, a method of manufacturing a semiconductor device, and a program.

### BACKGROUND

In a substrate processing apparatus, an optimal recipe may be created to perform a desired process on a substrate. For example, in the related art, there is known a technique in which, when displaying a recipe editing screen and creating a recipe, a process is time-divided and a processing condition corresponding to each divided section is set.

Incidentally, when editing a recipe, various parameters are often set for each step. It is difficult to grasp changes in control values obtained by calculating time-series parameters from the edited recipe. This may lead to a decrease in work efficiency during recipe editing.

### SUMMARY

Some embodiments of the present disclosure provide a technique capable of improving a work efficiency when editing a recipe.

According to embodiments of the present disclosure, there is provided a technique that includes: a substrate processor configured to process a substrate according to a recipe including at least one step defining a substrate processing condition; an operator configured to receive an editing operation for at least one setting item included in the substrate processing condition; a calculator configured to calculate a control value for a setting value of the at least one setting item in conformity with an edited substrate processing condition obtained by the editing operation; and a controller configured to be capable of controlling a display to display time-series data of the control value calculated by the calculator together with information about the at least one step.

### BRIEF DESCRIPTION OF DRAWINGS

The accompanying drawings, which are incorporated in and constitute a part of the specification, illustrate embodiments of the present disclosure.
FIG. 1 is a perspective view showing an example of a substrate processing apparatus according to embodiments of the present disclosure.
FIG. 2 is a side cross-sectional view of a substrate processing apparatus according to embodiments of the present disclosure.
FIG. 3 is a block diagram illustrating an example of a functional configuration of a controller included in a substrate processing apparatus according to embodiments of the present disclosure.
FIG. 4 is a front view showing an example of a recipe editing screen according to embodiments of the present disclosure.
FIG. 5 is a front view showing an example of an ITEM type selection screen according to embodiments of the present disclosure.
FIG. 6 is a front view showing an example of a calculation result display screen according to embodiments of the present disclosure.
FIG. 7 is a flowchart illustrating an example of a flow of a simulation process according to embodiments of the present disclosure.
FIG. 8 is a subroutine showing an example of a flow of a simulation execution process in step S 102 shown in FIG. 7.
FIG. 9 is a front view showing an example of a calculation result display screen according to other embodiments of the present disclosure.
FIG. 10 is a front view showing an example of a calculation result display screen according to other embodiments of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to unnecessarily obscure aspects of the various embodiments.

### <Embodiments of the Present Disclosure>

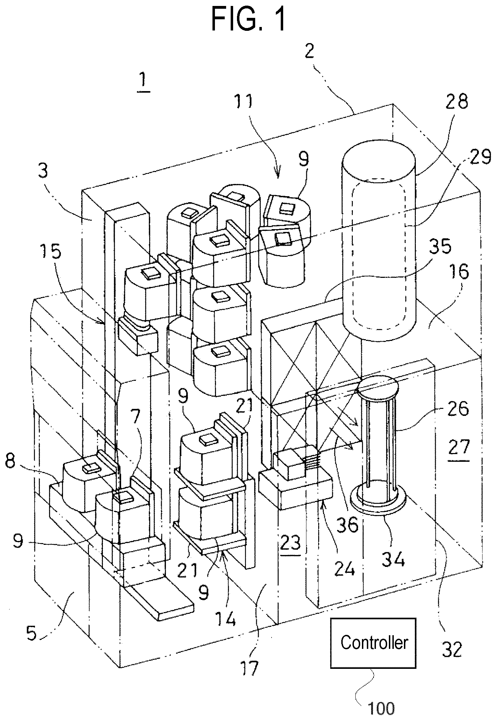

Hereinafter, embodiments of the present disclosure will be described mainly with reference to FIGS. 1 to 8. The drawings used in the following description are schematic, and dimensional relationships, ratios, and the like of the respective components shown in the drawings may not match actual ones. Further, dimensional relationships, ratios, and the like of the respective components among plural drawings may not match one another. Further, the present disclosure is not limited to the following embodiments, and may be implemented with appropriate changes within the scope of the present disclosure.

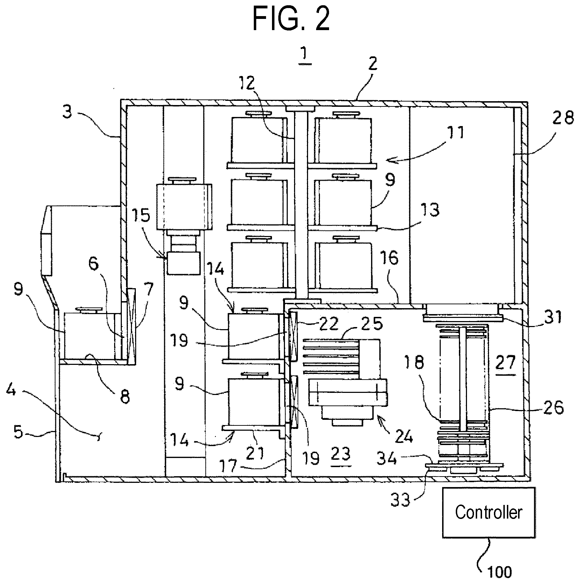

First, an overview of a substrate processing apparatus according to the embodiments of the present disclosure will be described with reference to FIGS. 1 and 2.

FIG. 1 is a perspective view showing an example of a substrate processing apparatus 1 according to the embodiments of the present disclosure. Further, FIG. 2 is a side cross-sectional view of the substrate processing apparatus 1 according to the embodiments of the present disclosure. FIGS. 1 and 2 show a vertical substrate processing apparatus 1 as an example of the substrate processing apparatus. A substrate that is processed in the substrate processing apparatus 1 is, for example, a semiconductor wafer made of silicon or the like.

As shown in FIGS. 1 and 2, the substrate processing apparatus 1 includes a housing 2. A front maintenance port 4 as an opening configured to allow maintenance is formed at a lower side of a front wall 3 of the housing 2. The front maintenance port 4 is opened or closed by a front maintenance door 5.

A pod loading/unloading port 6 is provided at the front wall 3 of the housing 2 to bring an inside and an outside of the housing 2 into fluid communication with each other. The pod loading/unloading port 6 is opened or closed by a front shutter (loading/unloading port opening/closing mechanism) 7. A load port (substrate transfer container delivery stand) 8 is installed at the front side of the pod loading/unloading port 6. The load port 8 is configured to align a pod 9 placed thereon.

The pod 9 is a sealed substrate transfer container, and is loaded onto or unloaded from the load port 8 by an in-process transfer apparatus (not shown).

A rotary pod shelf (substrate transfer container storage shelf) 11 is installed at an upper side approximately at a center in a front-rear direction in the housing 2. The rotary pod shelf 11 is configured to store a plurality of pods 9.

The rotary pod shelf 11 includes a column 12 installed vertically and configured to rotate intermittently, and a plurality of shelf plates (substrate transfer container mounting shelves) 13 radially supported by the column 12 at upper, middle, and lower positions. Each of the shelf plates 13 is configured to store at least one pod 9 mounted thereon.

A pod opener (substrate transfer container lid opening/closing mechanism) 14 is provided below the rotary pod shelf 11. The pod opener 14 is configured to be capable of mounting the pod 9 thereon and opening or closing the lid of the pod 9.

A pod transporter (container transporter) 15 is installed among the load port 8, the rotary pod shelf 11, and the pod opener 14. The pod transporter 15 may hold the pod 9 and move the same vertically or horizontally. The pod transporter 15 is configured to transport the pod 9 among the load port 8, the rotary pod shelf 11, and the pod opener 14.

A sub-housing 16 is provided at a lower side substantially at a center in a front-rear direction in the housing 2 so as to extend over a rear end. At a front wall 17 of the sub-housing 16, a pair of wafer loading/unloading ports (substrate loading/unloading ports) 19 configured to load or unload wafers (substrates) 18 into or out of the sub-housing 16 are formed in two stages of upper and lower stages in the vertical direction. The pod opener 14 is installed for each of upper and lower wafer loading/unloading ports 19.

The pod opener 14 includes a mounting stand 21 on which the pod 9 is mounted, and an opening/closing mechanism 22 configured to open or close the lid of the pod 9. The pod opener 14 is configured to open or close a wafer entrance of the pod 9 by opening or closing the lid of the pod 9 mounted on the mounting stand 21 by using the opening/closing mechanism 22.

The sub-housing 16 constitutes a conveyance chamber 23 that is kept airtight from a space (pod transport space) in which the pod transporter 15 and the rotary pod shelf 11 are arranged. A wafer conveyor (substrate conveyor) 24 is installed in the front region of the conveyance chamber 23, and the wafer conveyor 24 includes a demanded number of (e.g., 5 in the figure) wafer mounting plates 25 configured to mount the wafers 18 thereon. The wafer mounting plates 25 may be linearly moved in the horizontal direction, rotated in the horizontal direction, or moved up or down. The wafer conveyor 24 is configured to charge or discharge the wafers 18 into or from a boat (substrate holder) 26.

A standby part 27 configured to accommodate and keep the boat 26 in a standby state is formed in the rear region of the conveyance chamber 23, and a vertical process furnace 28 is provided above the standby part 27. The process furnace 28 includes a process chamber 29 formed therein. A furnace opening is provided at a lower end of the process chamber 29, and the furnace opening is opened or closed by a furnace opening shutter (furnace opening/closing mechanism) 31. The process chamber 29 is also referred to as a process container, and is an example of a substrate processor (substrate processing part).

A boat elevator (substrate holder elevator) 32 configured to raise or lower the boat 26 is installed between a right end of the housing 2 and a right end of the standby part 27 of the sub-housing 16. A seal cap 34 serving as a lid is horizontally attached to an arm 33 connected to an elevating stand of the boat elevator 32. The seal cap 34 is configured to be capable of supporting the boat 26 vertically, and airtightly sealing the furnace opening in a state in which the boat 26 is loaded into the process chamber 29.

The boat 26 is configured to hold a plurality of wafers 18 (e.g., about 50 to 125 wafers) in such a state that the wafers are arranged in a horizontal posture and in multiple stages with centers of the wafers aligned with one another. In the present disclosure, a notation of a numerical range such as "50 to 125 wafers" means that a lower limit value and an upper limit value are included in the range. Therefore, for example, "50 to 125 wafers" means "50 wafer or more and 125 wafers or less." The same applies to other numerical ranges.

A cleaner 35 is disposed at a position facing the boat elevator 32, and the cleaner 35 includes a supply fan and a dust filter to supply a clean air 36, which is a purified atmosphere or inert gas. As the inert gas, for example, a nitrogen (N)-containing gas may be used. As the N-containing gas, for example, a nitrogen (N₂) gas or the like may be used. As the N-containing gas, one or more of these gases may be used. A notch aligner (not shown) as a substrate aligner configured to align positions of the wafers 18 in a circumferential direction thereof is installed between the wafer conveyor 24 and the cleaner 35.

The clean air 36 blown out from the cleaner 35 is distributed to the notch aligner (not shown), the wafer conveyor 24, and the boat 26. Then, the clean air is sucked into the duct (not shown), and is discharged to the outside of the housing 2 or blown into the conveyance chamber 23 by the cleaner 35.

Next, an operation of the substrate processing apparatus 1 will be described. At least one of units or components described below, which performs the operation of the substrate processing apparatus 1 according to a substrate process recipe described later, is another example of the substrate processor (substrate processing part).

When the pod 9 is supplied to the load port 8, the pod loading/unloading port 6 is opened by the front shutter 7. The pod 9 on the load port 8 is loaded into the housing 2 via the pod loading/unloading port 6 by the pod transporter 15, and is mounted on a designated shelf plate 13 of the rotary pod shelf 11. After being temporarily stored on the rotary pod shelf 11, the pod 9 is transferred from the shelf plate 13 to one of the pod openers 14 and conveyed to the mounting stand 21, or is directly conveyed from the load port 8 to the mounting stand 21 by the pod transporter 15.

At this time, the wafer loading/unloading port 19 is closed by the opening/closing mechanism 22, and the conveyance chamber 23 is filled with the clean air 36 flowing therethrough. For example, by filling the conveyance chamber 23 with a N-containing gas as the clean air 36, an oxygen concentration is set to 20 ppm or less, which is lower than an oxygen concentration of an inside (air atmosphere) of the housing 2.

When an opening-side end surface of the pod 9 mounted on the mounting stand 21 is pressed against an opening edge of the wafer loading/unloading port 19 on the front wall 17 of the sub-housing 16, the lid is removed by the opening/closing mechanism 22 to open the wafer entrance.

When the pod 9 is opened by the pod opener 14, the wafer 18 is discharged from the pod 9 by the wafer conveyor 24, and transferred to the notch aligner (not shown). After the wafer 18 is aligned by the notch aligner, the wafer conveyor 24 loads the wafer 18 to the standby part 27 located at the rear of the conveyance chamber 23, and charges the wafer 18 into the boat 26.

After conveying the wafer 18 to the boat 26, the wafer conveyor 24 returns to the pod 9 and charges the next wafer 18 into the boat 26.

While the wafer 18 is being charged into the boat 26 by the wafer conveyor 24 at one (upper or lower) pod opener 14, another pod 9 is conveyed from the rotary pod shelf 11 into the other (lower or upper) pod opener 14 by the pod transporter 15, and an opening operation of the pod 9 by the other pod opener 14 is simultaneously performed.

When a predetermined number of wafers 18 are charged into the boat 26, the furnace opening of the process furnace 28 closed by the furnace opening shutter 31, is opened by the furnace opening shutter 31. Subsequently, the boat 26 is moved up by the boat elevator 32 and loaded into the process chamber 29.

After the loading, the furnace opening is hermetically closed by the seal cap 34. In the embodiments of the present disclosure, at this timing (after the loading), a purge step (pre-purge step) is performed in which the atmosphere inside the process chamber 29 is replaced with an inert gas.

The process chamber 29 is vacuum-exhausted to a desired pressure (state of vacuum) by a gas exhauster (not shown). Further, the process chamber 29 is heated to a predetermined temperature by a heater driver (not shown) such that a temperature distribution in the process chamber 29 becomes a desired temperature distribution.

In addition, a gas supplier (not shown) supplies a processing gas whose flow rate is controlled to be a predetermined flow rate. In process of flowing through the process chamber 29, the processing gas comes into contact with a surface of the wafer 18 to perform a predetermined process on the surface of the wafer 18. Further, the processing gas after going through a reaction is exhausted from the process chamber 29 by the gas exhauster. The processing gas referred to herein refers to the gas supplied into the process chamber 29. The same applies to the following description.

When a preset processing time elapses, an inert gas is supplied from an inert gas supply source (not shown) by the gas supplier to replace the atmosphere inside the process chamber 29 with the inert gas, and a pressure inside the process chamber 29 is returned to an atmospheric pressure (after-purge process). Then, the boat 26 is lowered by the boat elevator 32 via the seal cap 34. In the present disclosure, a processing time refers to a time during which the process continues. The same applies to the following description.

When the processed wafers 18 are unloaded, the wafers 18 and the pod 9 are unloaded to the outside of the housing 2 in the reverse procedure to the procedure described above. Unprocessed wafers 18 are charged into the boat 26 again, and a batch process of the wafers 18 is repeated.

As shown in FIGS. 1 and 2, the substrate processing apparatus 1 includes a controller 100, which controls the substrate processing apparatus 1. The controller 100 may be built into the substrate processing apparatus 1 or may be accessibly provided outside the substrate processing apparatus 1.

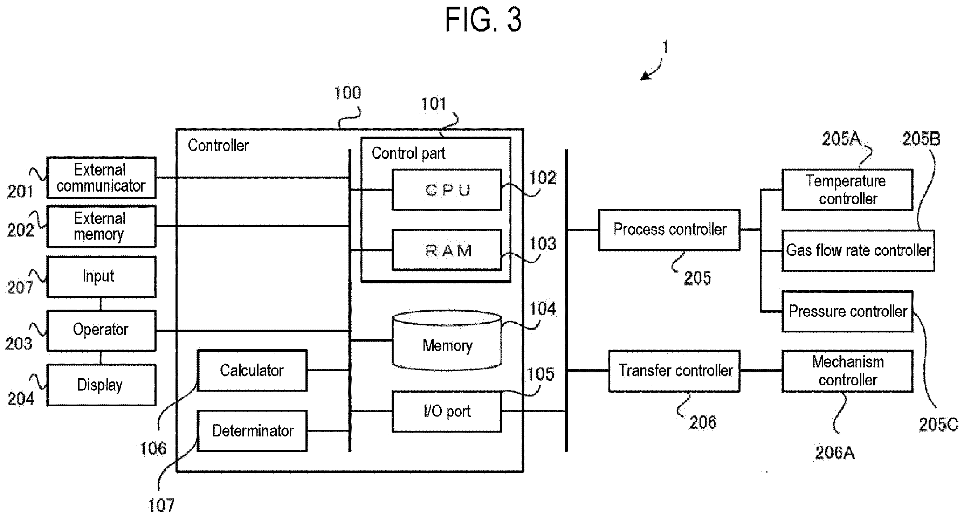

Next, a configuration of a control system of the substrate processing apparatus 1 according to the embodiments of the present disclosure will be described with reference to FIG. 3. FIG. 3 is a block diagram showing an example of a functional configuration of the controller 100 included in the substrate processing apparatus 1 according to the embodiments of the present embodiment.

As shown in FIG. 3, the substrate processing apparatus 1 includes a controller (main controller) 100, an external communicator 201, an external memory 202, an operator (operating part) 203, a displayer (display part) 204, an input (input part) 207, a process controller 205, and a transfer controller 206.

The controller 100 further includes a control part 101, a memory 104, an I/O port 105, a calculator 106, and a determinator 107. The control part 101 includes a CPU (Central Processing Unit) 102 and a RAM (Random Access Memory) 103. The calculator 106 and the determinator 107 are shown separately from the control part 101, but may be implemented as a function of the control part 101. Similarly, the operator 203 may be implemented as a function of the control part 101.

The controller 100 is connected to the operator 203 and is also connected to the process controller 205 and the transfer controller 206 via the I/O port 105. Since the controller 100 is electrically connected to each of the process controller 205 and the transfer controller 206 via the I/O port 105, the controller 100 is configured to be capable of performing transmission and reception of various data, downloading and uploading of various files, and the like.

The controller 100 is connected to an external host computer (not shown) via the external communicator 201. Therefore, even in a case where the substrate processing apparatus 1 is installed in a clean room, the host computer may be installed in an office or the like outside the clean room. Further, the external memory 202 as a mounter into which a USB (Universal Serial Bus) memory, as an example of a recording medium, is removably inserted, is connected to the controller 100.

The operator 203 as an operation controller includes a displayer 204 and an input 207 integrally. Alternatively, the operator 203 may be connected to the displayer 204 via a video cable or the like, and may be connected to the input 207 via a signal cable or the like. The displayer 204 is, for example, a liquid crystal display panel. The input 207 is, for example, an input such as a keyboard or a mouse. Further, the operator 203, the displayer 204, and the input 207 may be integrally configured by a touch panel. The displayer 204 is configured to display various operation screens by which the substrate processing apparatus 1 is operated. The operation screen includes a screen configured to check statuses of a substrate process system controlled by the process controller 205 and a substrate transfer system controlled by the transfer controller 206. The displayer 204 may also display operation buttons and input fields as an input interface (input means or unit) configured to input operation instructions to the substrate process system and the substrate transfer system. Each operation button is selected or pressed via the operator 203 based on instructions inputted from the input 207. Further, numerical values and the like are inputted into each input field via the operator 203 based on instructions inputted from the input 207. The operator 203 causes the displayer 204 to display information generated within the substrate processing apparatus 1. Further, the operator 203 outputs, for example, information inputted from the input 207 and information displayed on the displayer 204 to an apparatus such as a USB memory inserted into the external memory 202. The operator 203 receives input data (input instructions) inputted from a user via the operation screen displayed on the displayer 204, and transmits the input data to the controller 100. Further, the operator 203 receives, via the input 207, an instruction (control instruction) that executes an arbitrary substrate processing recipe (also referred to as a process recipe) among the recipes developed in the RAM 103 or a plurality of recipes stored in the memory 104, and transmits the instruction to the controller 100. The operator 203 and the displayer 204 are provided separately from the controller 100 in the illustrated example, but may be integrally included in the controller 100.

The process controller 205 includes a temperature controller 205A, a gas flow rate controller 205B, and a pressure controller 205C. The temperature controller 205A, the gas flow rate controller 205B, and the pressure controller 205C respectively constitute sub-controllers and are electrically connected to the process controller 205, which makes it possible to send or receive data, and download or upload files. The process controller 205 and the respective sub-controllers (the temperature controller 205A, the gas flow rate controller 205B, and the pressure controller 205C) are shown separately, but may be integrally configured.

A heating mechanism mainly including a heater and a temperature sensor (not shown) is connected to the temperature controller 205A. The temperature controller 205A is configured to regulate the temperature inside the process furnace 28 by controlling the temperature of the heater of the process furnace 28. The temperature controller 205A is configured to perform a switching (on/off) control of a thyristor and control a power supplied to a heater wire.

A MFC (Mass Flow Controller) (not shown) as a gas flow rate controller installed on a gas pipe configured to supply a predetermined gas into the process chamber 29 and configured to control a flow rate of the supplied gas is connected to the gas flow rate controller 205B. When an on-off valve (valve) other than the MFC is installed on the gas pipe, the gas flow rate controller 205B may be configured to control the on-off valve as well as the MFC. The gas flow rate controller 205B is configured to control a valve opening state of the MFC such that the flow rate of the gas supplied into the process chamber 29 becomes an instructed value. Alternatively, the MFC may be constituted as the gas flow rate controller 205B, and the MFC may be directly connected to the process controller 205.

A gas exhauster (not shown) mainly including a pressure sensor (not shown) and an APC (automatic pressure control) valve (not shown) as a pressure valve is connected to the pressure controller 205C. A vacuum pump (not shown) may be included in the gas exhauster. The pressure controller 205C is configured to control an opening state of the APC valve and switching (on/off) of the vacuum pump based on a pressure value detected by the pressure sensor such that the pressure in the process chamber 29 reaches an instructed pressure at an instructed timing.

The transfer controller 206 includes a mechanism controller 206A. The mechanism controller 206A is configured to control each of a driver system, a rotator system, and an elevating system of the substrate processing apparatus 1. The transfer controller 206 is configured to control transfer operations of the rotary pod shelf 11, the boat elevator 32, the pod transporter 15, the wafer conveyor 24, the boat 26, and a rotator (not shown).

In addition, the controller 100, the process controller 205, and the transfer controller 206 according to the embodiments of the present disclosure may be realized by using a typical computer system without being limited to a dedicated system. For example, by installing on a general-purpose computer a program, which executes the above-described processes, from a recording medium (a CD-ROM, a USB, or the like) that stores the program, it is possible to constitute each controller configured to execute a predetermined process.

A configuration of supplying these programs is optional. In addition to supplying the programs via the predetermined recording medium as described above, the programs may be supplied, for example, via a communication line, a communication network, a communication system, and the like.

The controller 100 is constituted as a computer including a CPU 102, a RAM 103, a memory 104, and an I/O port 105. The memory 104 stores recipe files such as recipes in which processing conditions and processing procedures are defined, control program files that execute these recipe files, parameter files (setting value files) that set processing conditions and processing procedures, error processing program files, error processing parameter files, various screen files including an input screen configured to input process parameters, various icon files, and the like (none of which are shown). The controller 100 is connected to a network such as the Internet, a LAN (Local Area Network), or a WAN (Wide Area Network) by using the external communicator 201, and is capable of communicating with external apparatuses via the network.

Further, as the memory 104, for example, a HDD (Hard Disk Drive), a SSD (Solid State Drive), a flash memory, or the like is used. The memory 104 stores a simulation process program that executes a simulation process according to the embodiments of the present disclosure.

The simulation process program may be installed in the substrate processing apparatus 1 in advance, for example. The simulation process program may be realized by being recorded on a nonvolatile recording medium or distributed via a network, and installed in the substrate processing apparatus 1 as appropriate. Examples of the nonvolatile recording medium include a CD-ROM, a magneto-optical disk, a HDD, a DVD-ROM, a flash memory, a memory card, a USB, and the like.

In other words, the simulation process program is a program that causes a computer to execute a procedure of processing a substrate by using a recipe including at least one step defining a substrate processing condition, a procedure of performing an editing operation on setting items of the processing condition, a procedure of calculating a control value for setting values of setting items in conformity with the edited processing condition, and a procedure of displaying, on the displayer 204, time-series data of the calculated control value together with information about the step.

The CPU 102 of the substrate processing apparatus 1 according to the embodiments of the present disclosure functions as the control part 101, the calculator 106, and the determinator 107 by writing the simulation process program stored in the memory 104 into the RAM 103 and executing the simulation process program.

The substrate processing apparatus 1 according to the embodiments of the present disclosure includes the process chamber 29, the control part 101, the memory 104, the calculator 106, the determinator 107, the operator 203, and the displayer 204.

In the process chamber 29, the substrate is processed according to the recipe including at least one step defining the substrate processing condition. That is, the recipe includes one or more steps.

The operator 203 receives editing operations such as addition, deletion, order change, repeated execution setting, and the like for the steps included in the recipe from a user via the input 207. Further, the operator 203 receives an editing operation for at least one setting item (e.g., "ITEM" to be described later) included in the processing condition of the selected step. That is, the operator 203 receives an editing operation for the step included in the recipe and an editing operation for at least one setting item included in the processing condition of each step from a user via an operation screen.

The calculator 106 calculates control values for the setting values of the setting items included in the processing condition, as a simulation process, based on one or more steps edited in the operator 203 and the processing condition defined in each step. The simulation process referred to herein is a process that calculates a control value for the setting value of the setting item as a simulation value based on the processing condition determined by the editing operation. More specifically, in the simulation process, changes in control values over time are calculated as time-series data. Upon receiving an instruction to execute the simulation process, the operator 203 instructs the control part 101 to perform the simulation process. The control part 101 controls the calculator 106 to perform calculation according to the instruction.

The "control value" referred to herein is a value that is calculated for the process controller 205 and/or the transfer controller 206 to control each component of the substrate processing apparatus 1 (e.g., any one of the temperature controller 205A, the gas flow rate controller 205B, the pressure controller 205C, and the mechanism controller 206A) based on the setting value inputted from the control part 101 via the I/O port 105. The control value is outputted from the process controller 205 and/or the transfer controller 206 to each component of the substrate processing apparatus 1 which operates based on the inputted control value.

That is, the calculator 106 according to the embodiments of the present disclosure calculates, as a simulation value, a control value that the process controller 205 and/or the transfer controller 206 calculates and outputs to actually control each component. In other words, the controller 100 is configured to allow the calculator 106 to calculate (simulate) a control value for each component without outputting processing condition values to the process controller 205 and/or the transfer controller 206.

In the embodiments of the present disclosure, the "control value" is a value calculated and obtained based on the setting value set for each setting item (setting ITEM) of each step, a control parameter (e.g., a ramp rate value) referred to in controlling each setting item, a step time of each step, an execution order of each step, and the like. In the embodiments of the present disclosure, a case where a ramp rate value is mainly used as the control parameter will be described by way of example. As the control parameter, in addition to the ramp rate value, for example, a PID parameter value that is referred to when performing a PID control on each setting item may also be used. The control parameter may also be regarded as an item of setting values. Hereinafter, the setting values and the control parameter may be collectively referred to as setting values.

The control part 101 controls the operator 203 such that the displayer 204 displays the time-series data of the control values calculated by the calculator 106 together with the information about the steps constituting the recipe.

Specifically, for example, when a target of calculation (i.e., the setting item for which the setting value is set) is a temperature of the process chamber 29, the calculator 106 calculates control values (time-series data of control values) in one or more steps based on the setting value related to the temperature of the process chamber 29, the ramp rate value, the step time of each step, the execution order of each step, and the like. In this case, the control values become information for an instruction on the temperature of the process chamber 29 that is sent from the process controller 205 to the temperature controller 205A. The calculated control values are stored in the memory 104 for each step. Under the control of the control part 101, the displayer 204 is configured to display the control values stored in the memory 104 as time-series data on a screen together with the information about one or more corresponding steps. The step time is set for each step. On the screen, for example, a horizontal axis indicates an elapsed time. The information about the steps, that includes step names and the like separated by the step time, is indicated near (e.g., at a lower side) the elapsed time to correspond to the time-series data of the control values. Further, at least one selected from the group of the setting values of the steps corresponding to the time-series data of the control values, the ramp rate value, and the calculated control values is displayed on the screen.

In this regard, the control value may change depending on the setting value and other factors including the control parameters such as the ramp rate value, the setting values of other setting items, the step time of each step, the execution order of each step. Therefore, it may be difficult for a user to determine whether an actual control value is an appropriate value based on the setting value. On the other hand, by calculating the control value as in the embodiments of the present disclosure, regarding the control value for each setting value of the recipe edited during recipe editing, it is possible to confirm consistency of the control value for each setting value without actually executing the recipe. In a case where the control value is not appropriate, it is possible to immediately return to the recipe editing and perform step organization that defines combination and execution order of steps constituting the recipe, and correction of the settings values set for the steps.

Further, by displaying the time-series data of the control values in correspondence with the information about the step, it is possible to easily understand which step the control value corresponds to. Accordingly, it is possible to improve a work efficiency during the recipe editing.

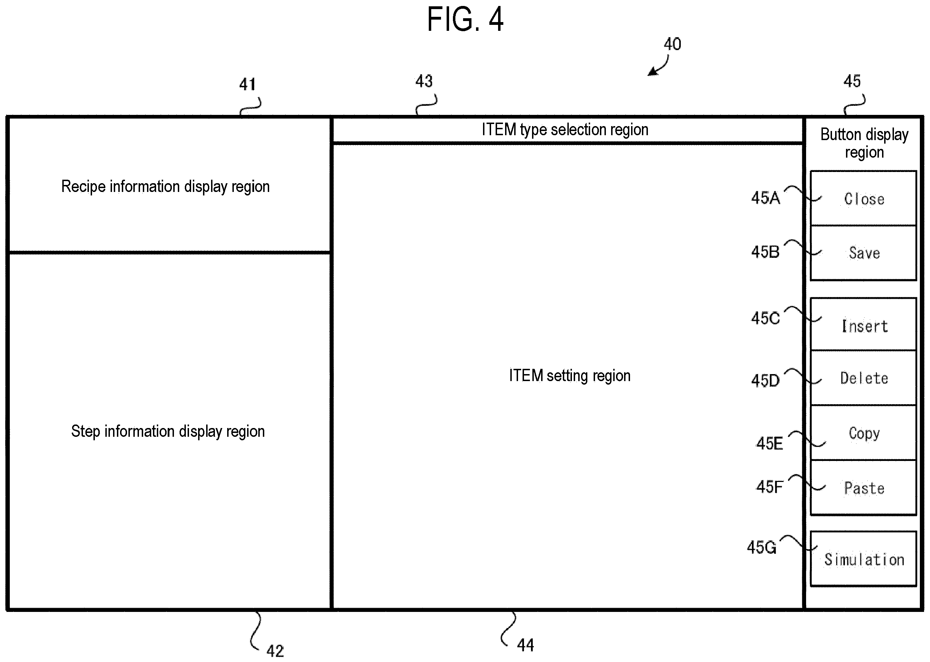

Next, examples of screen transitions on the displayer 204 accompanying a simulation process according to the embodiments of the present disclosure will be specifically described with reference to FIGS. 4 to 6.

FIG. 4 is a front view showing an example of a recipe editing screen 40 according to the embodiments of the present embodiment. The recipe editing screen 40 shown in FIG. 4 includes a recipe information display region 41, a step information display region 42, an ITEM type selection region 43, an ITEM setting region 44, and a button display region 45.

The recipe information display region 41 displays, for example, the recipe type, the recipe name, the step number currently selected among the steps registered in the recipe, and the like. The step information display region 42 displays a list of step information registered in the recipe. The step information includes, for example, the step number, the step name, presence or absence of an execution command, presence or absence of settings for various ITEMs in the step, and the like.

In the ITEM type selection region 43, the types of ITEMs to be displayed in the ITEM setting region 44 are displayed in a selectable manner. For example, in the ITEM type selection region 43, a plurality of ITEM types is displayed in a pull-down format or a tab format such that one of the plurality of ITEM types may be selected. The ITEM referred to herein is an example of a setting item in each step. The types of selectable ITEMs include fixed information, the temperature, the pressure, the state information, the loader (transporter), the MFC, the combination information, the step time, the number of step loops, and the like. The status information referred to herein is also referred to as a gas pattern, and is information indicating a state of at least one selected from the group of a gas pipe and a valve. The state of the gas pipe represents a gas flow rate, and the state of the valve represents whether the valve is on or off.

The ITEM setting region 44 is a region configured to set one or more ITEMs belonging to the ITEM type selected in the ITEM type selection region 43. Items that may be set for respective ITEMs, which are examples of setting items, include ITEM names, setting values, control parameters (ramp rate values, etc.), and the like. The items that may be set for respective ITEMs vary depending on the ITEM type selected in the ITEM type selection region 43. When "temperature" is selected in the ITEM type selection region 43, for example, temperatures of one or more heaters configured to heat the inside of the process chamber 29, or temperatures of a plurality of heater zones that divide the inside of the process chamber 29 are listed in the ITEM setting region 44 as ITEMs.

The setting values and the control parameters in each step may be configured so that they may be directly inputted or changed by a user on the recipe editing screen 40. Further, the setting values and the control parameters may be inputted or changed through different editing screens or the like for the respective steps, instead of the recipe editing screen 40.

The button display region 45 displays a plurality of buttons in which actions that may be executed on the recipe editing screen 40 are defined. In the button display region 45, for example, a Close button 45A, a Save button 45B, an Insert button 45C, a Delete button 45D, a Copy button 45E, a Paste button 45F, and a Simulation button 45G are displayed.

When the Close button 45A is pressed (for example, by a touch operation, a cursor operation, etc.), an operation of closing the recipe editing screen 40 is executed. When the Close button 45A is pressed during recipe editing, a pop-up screen is displayed to confirm saving. When the Save button 45B is pressed, an operation of saving the contents edited on the recipe editing screen 40 is executed. When the Insert button 45C is pressed, an operation of inserting a step into the recipe under editing is executed. When the Delete button 45D is pressed, an operation of deleting, from the recipe under editing, the step currently selected is executed. When the Copy button 45E is pressed, an operation of copying information about a designated step to a temporary memory or the like is executed. When the Paste button 45F is pressed, an operation in which the information about the step copied by using the Copy button 45E is pasted to the designated step is executed. When the Simulation button 45G is pressed, the above-described simulation process is executed.

In this regard, the operator 203 is configured to be capable of instructing the control part 101 to calculate a control value during an editing operation of an ITEM, which is an example of a setting item. Specifically, for example, when the Simulation button 45G is pressed while editing a recipe on the recipe editing screen 40 shown in FIG. 4, the operator 203 instructs the control part 101 to calculate a control value regarding the ITEM type selected on the ITEM type selection screen 50, which will be described later, and the control part 101 instructs the calculator 106 to calculate the control value.

Therefore, even during recipe editing, it is possible to check whether the setting value of each ITEM at that time is appropriate. This prevents incorrect recipe settings.

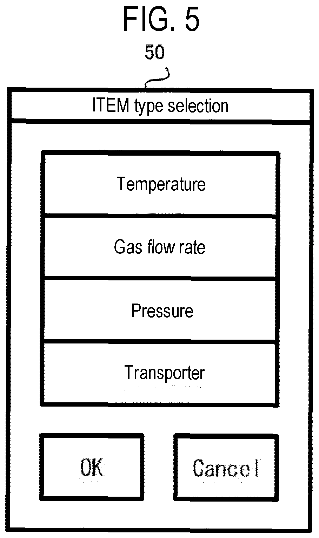

FIG. 5 is a front view showing an example of the ITEM type selection screen 50 according to the embodiments of the present disclosure. The ITEM type selection screen 50 shown in FIG. 5 is displayed as a dialog screen or a pop-up screen when the Simulation button 45G on the recipe editing screen 40 of FIG. 4 is pressed.

The ITEM type selection screen 50 shown in FIG. 5 displays, for example, the temperature, the gas flow rate, the pressure, and the transporter (loader) as the types of ITEMs to be subjected to a simulation process such that at least one selected from the group of the temperature, the gas flow rate, the pressure, and the transporter (loader) may be selected.

At this time, the operator 203 acquires, as type information, the information indicating the type of ITEM on which the simulation process, i.e., the control value calculation is performed, based on the selection. The type information includes, for example, information about at least one selected from the group of the temperature, the gas flow rate, the pressure, and the transporter (loader). Specifically, for example, the ITEM type selected by a user via the ITEM type selection screen 50 shown in FIG. 5 is acquired by the operator 203 as the type information. In FIG. 5, the ITEM type is an example of the type information. After a user selects at least one selected from the group of the temperature, the gas flow rate, the pressure, and the transporter (loader) on the ITEM type selection screen 50 and presses the "OK" button, the selection of the ITEM type is finalized. The number of ITEM types to be selected may be one or multiple. The operator 203 notifies the control part 101 of the selected ITEM type, and then the control part 101 closes the ITEM type selection screen 50. On the other hand, when the "Cancel" button is pressed, the selection of the ITEM type is cleared and the ITEM type selection screen 50 is closed.

That is, instead of calculating control values for the entirety of ITEM types at once, it may be possible to calculate control values for pre-selected ITEM types. Therefore, a processing load when calculating the control values is alleviated. The simulation process is not limited to the case where the simulation process is performed on the entirety of ITEMs belonging to each ITEM type, but the control values of one or more selected ITEMs may be calculated. For example, the simulation process may be performed for one or more setting items (ITEMs) selected at the time when the Simulation button 45G is pressed, without displaying the ITEM type selection screen 50. Further, when an ITEM type is selected on the ITEM type selection screen 50, an ITEM selection screen may be further displayed on which one or more ITEMs belonging to the selected ITEM type may be selected, and the simulation process may be performed for one or more ITEMs selected on the ITEM selection screen.

The calculator 106 may change, regardless of an order of steps set in a single recipe that is the target of the editing operation, the execution order of the steps in conformity with an actual substrate processing operation according to settings of other recipes. A recipe may specify execution of other recipes (e.g., sub-recipes or alarm recipes), jumping to a target step, or repeating a step. Therefore, the order of the edited steps may differ from the order of the steps at the time of execution. Since the control value is also changed depending on the state of the controlled target in an immediately preceding step, the control value may also be changed due to the difference in the order of the steps. Therefore, it is desired that the order of steps may be changed in conformity with the specified contents of the steps such that the time-series data of the control values are closer to the actual operation,

In other words, by changing the execution order of the steps in conformity with the actual substrate processing operation, the time-series data of the control values may be closer to the step operation during the actual substrate processing process. Therefore, a reliability of the calculated control value may be improved. Further, when displaying the time-series data of the control values on the screen, the data may be displayed in the changed order of execution of steps.

Further, the time-series data of the control values calculated by the calculator 106 may be stored in the memory 104 in association with the order of execution of steps during the actual operation. In other words, the time-series data of the control values obtained through the calculation are stored in the memory 104 in the order of reconfigured steps, i.e., in the order of the changed steps.

The data may be temporarily stored in the RAM 103 instead of the memory 104. Further, as the external memory 202, a USB memory, a CD, a DVD, or the like, which is an example of a recording medium, may be connected to store the data. Alternatively, another apparatus or a management PC may be connected via the external communicator 201 to store the data. In this case, for example, an external apparatus may be connected via an external recording medium or a network to store time-series data of control values, which makes it possible to secure a memory region inside the apparatus.

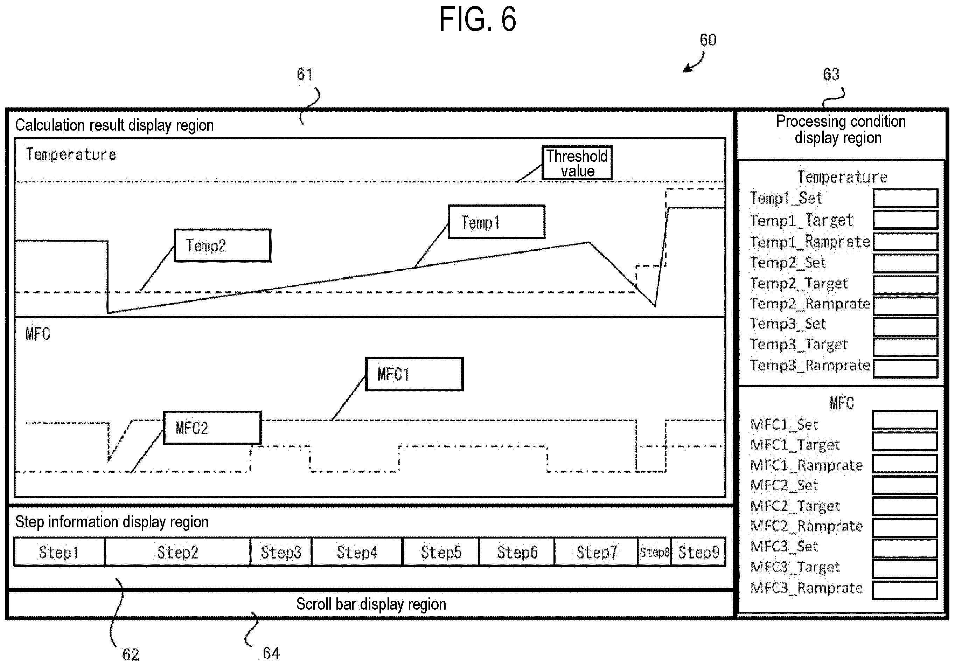

FIG. 6 is a front view showing an example of a calculation result display screen 60 according to the embodiments of the present disclosure. The calculation result display screen 60 shown in FIG. 6 is displayed when the ITEM type is selected on the ITEM type selection screen 50 of FIG. 5 and the "OK" button is pressed. The screen shown in FIG. 6 is, for example, a screen available when "temperature" and "gas flow rate (MFC)" are selected.

As shown in FIG. 6, the displayer 204 includes a calculation result display screen 60, which is an example of a screen configured to display time-series data of control values. The displayer 204 is configured to display time-series data of control values of one or more steps included in the recipe on the calculation result display screen 60 in conformity with the execution order of the steps.

That is, the displayer 204 acquires the control values stored in the memory 104 from the beginning of each step and displays them as time-series data. For example, the data to be displayed as time-series data may be displayed as a chart connecting the control values of the respective steps, or may be displayed as bar graphs for the respective steps. Alternatively, a difference between before-and-after steps may be displayed in a bar graph.

In this case, by displaying the control values calculated for each step as time-series data in a chart, it is possible to clearly understand changes in the before-and-after steps. Further, by displaying the difference between the before-and-after steps in a bar graph, it is possible to more clearly understand the changes from the preceding step.

The calculation result display screen 60 shown in FIG. 6 includes, for example, a calculation result display region 61, a step information display region 62, a processing condition display region 63, and a scroll bar display region 64.

The calculation result display region 61 is an example of a first display region, and is a region configured to display time-series data of control values. Specifically, the calculation result display region 61 displays the control value of the selected ITEM type as time-series data. When a plurality of ITEM types is selected, the ITEM types are displayed, for example, in a vertically divided pattern. A horizontal axis indicates the time (the time elapsed since execution of the recipe), and a vertical axis indicates a scale of the selected ITEM type. For example, in the case of a temperature, the vertical axis indicates "Celsius or Fahrenheit," and in the case of a MFC, the vertical axis indicates "flow rate."

The step information display region 62 is an example of a second display region, and is a region configured to display information about the step. Specifically, the step information display region 62 displays the information about the step in which the ITEM of the selected ITEM type is set. The information about the step is, for example, the name of the step. Further, when executing another recipe while executing the step, information about a step of another recipe may be displayed at a lower side of a main recipe. Alternatively, the display may be performed to distinguish between the main recipe and another recipe.

For example, by providing the information about the step at a lower side of time-series data of control values, it becomes possible to clearly understand a relationship between the calculated control values and the step. Therefore, in a case where incorrect settings are made, an abnormal step may be easily identified.

The processing condition display region 63 is an example of a third display region, and is a region configured to display the processing condition. Specifically, the processing condition display region 63 displays, for example, at least one selected from the group of setting items, setting values, control values, and control parameters of the selected step. In the example of FIG. 6, "Temperature" indicating the temperature and "MFC" indicating the gas flow rate are displayed as the setting items.

More specifically, the processing condition display region 63 displays, for example, a list of the calculated ITEM type processing conditions on the right side of the time-series data of the control values. The displayed processing conditions include, for example, setting values, control values, and ramp rate values for each ITEM type. Items other than the setting values and the control values vary depending on the ITEM type. For example, in a case where the selected ITEM is the temperature or the MFC, the ramp rate values may also be displayed. In the example of FIG. 6, the setting item is shown as "Temperature," the setting value is shown as "Temp1_Set," the control value is shown as "Temp1_Target," and the ramp rate value is shown as "Temp1_Ramprate." The same applies to "Temp2" and "Temp3." The setting item is shown as "MFC," the setting value is shown as "MFC1_Set," the control value is shown as "MFC1_Target," and the ramp rate value is shown as "MFC1_Ramprate." The same applies to "MFC2" and "MFC3."

Further, when the time-series data of control values is touched, the value of the step corresponding to the touched time-series data is displayed. For example, in the case of temperature, the setting value, the control value, and the ramp rate value of the touched step are displayed. Further, when the time-series data of control values is touched, the value at the time on the touched time-series data (e.g., the elapsed time from the start of the recipe), for example, in the case of temperature, the control value at the time of touch may be displayed. It may be difficult to check an accurate value of the control value by using time-series data of control values. Therefore, by touching the region of the step to be checked in the time-series data of control values, it is possible to check the control values and the like relating to the step designated by the touch.

The scroll bar display region 64 is an example of a fourth display region, and is a region configured to display a scroll bar that scrolls and displays time-series data of control values. The displayer 204 switches a display position of the time-series data of control values in accordance with the scroll bar of the scroll bar display region 64.

Via the operator 203, the control part 101 may cause the displayer 204 to display the time-series data of control values in conjunction with the recipe execution result, which is a result of processing the substrate by using the recipe, such that the time-series data of control values may be compared with the recipe execution result. Specifically, on the calculation result display screen 60, the recipe execution result obtained when the substrate is precedingly processed by using the recipe and the time-series data of control values may be displayed in a superimposed manner.

By superimposing the recipe execution result and the time-series data of control values, it becomes possible to compare the recipe execution result and the time-series data of control values, and it is possible to easily specify a corrected portion of the recipe.

In addition, via the operator 203, the control part 101 may cause the displayer 204 to display the time-series data of control values calculated by using the recipe in conjunction with the time-series data of control values calculated by other recipes. Specifically, it is possible to store a plurality of recipes in the memory 104. On the calculation result display screen 60, the time-series data of the control values calculated by using the recipe and time-series data of control values for another similar recipe among a plurality of recipes may be displayed in a superimposed manner.

By superimposing and displaying time-series data of control values calculated by using different recipes in the same apparatus, it is possible to check differences in the control values among the recipes.

In addition, via the operator 203, the control part 101 may cause the displayer 204 to display the time-series data of the control values calculated by its own apparatus in conjunction with time-series data of control values calculated by another apparatus in a time-series order. Specifically, for example, when there is a basic master apparatus, it is conceivable to newly install an apparatus (hereinafter referred to as "similar apparatus") similar to the master apparatus. Therefore, on the calculation result display screen 60, the time-series data of the control values calculated according to the recipe set on the similar apparatus and the time-series data of the control values calculated according to the recipe set on the master apparatus may be displayed in a superimposed manner.

This makes it possible to identify errors in recipe settings between the master apparatus and the similar apparatus and differences in recipe settings due to errors between the apparatuses.

In addition, the displayer 204 may display by arranging the time-series data of control values and state information indicating a state of at least one selected from the group of the gas pipe and the valve, and may display the time-series data of control values of a specified step and the state information on one screen. Specifically, on the calculation result display screen 60, for example, the display region for the time-series data of control values and the step information may be made smaller, and the state information may be arranged to be displayed in the empty space. Further, the state information indicating the state of at least one selected from the group of the gas pipe and the valve may be displayed as a layout diagram (gas pattern diagram) indicating a connection relationship between the gas pipe and the valve.

For example, when the gas pipe and the valve are selected from the ITEMs, the state information indicating the state of at least one selected from the group of the gas pipe and the valve is displayed on one screen. Therefore, it is possible to easily check a gas flow rate at each step and a gas flow condition due to on/off of the valve.

Further, via the operator 203, the control part 101 may cause the calculator 106 to calculate a processing condition under which the substrate processing process edited by the operator 203 is terminated abnormally. In this case, the control part 101 determines whether or not an abnormal operation according to the recipe is appropriate based on the processing condition under which the abnormal termination occurs calculated by the calculator 106. In other words, the processing condition under which the recipe execution result becomes abnormal, for example, a processing condition that causes an alarm recipe or an abort recipe as another recipe to be executed during execution of the step is set, and the calculation is performed to check the operation when the recipe is abnormal.

By deliberately setting the processing condition under which the recipe execution result becomes abnormal, it is possible to easily check a process that is difficult to check even in an actual apparatus, for example, an operation of an alarm recipe or an abort recipe.

Further, as shown in FIG. 6, a threshold value may be set for the time-series data of control values. Although the threshold value is defined for each ITEM, it may be common to respective ITEMs. The threshold value is calculated based on, for example, preceding experiments, a master apparatus, preceding recipe execution results, and the like, and is stored in the memory 104. The threshold value may be calculated for each step or for the entire recipes. The threshold value may be an upper limit value, or may be an upper limit value and a lower limit value, depending on the ITEM type. Although not shown, display/non-display of the threshold value may be specified.

The determinator 107 determines whether the control value calculated by the calculator 106 is correct or not. Specifically, the determinator 107 determines whether the control value is correct or not for each ITEM of the recipe according to a predetermined determination condition. The predetermined determination condition referred to herein is the above-mentioned threshold value, i.e., the threshold value that is set based on the result of processing the substrate according to the recipe. In a case where the threshold value is exceeded, the determinator 107 determines that the recipe may not be executed based on the control value.

Through the control value determination process described above, it is possible to check erroneous setting of a setting value relating to the control value or a ramp rate value. Further, by setting the threshold value based on the results obtained when the substrate is normally processed, it is possible to improve an accuracy of determining the control value.

The displayer 204 may display an ITEM whose processing condition is determined as not being capable of executing the recipe as a result of the determination by the determinator 107, in a manner different from that of other ITEMs. Specifically, when there is an ITEM that exceeds a threshold value on the calculation result display screen 60, for example, display of the corresponding step information is made different from that of other step information. For example, a background color of a pertinent step name may be changed, or color of character of the pertinent step name may be changed. The changes in the display format include changes in color and various changes such as changes in character font, addition of character decorations such as underlining, and changes in character size. This makes it clear that there is an ITEM that exceeds the threshold value. Further, by touching the time-series data of the control value of the step exceeding the threshold value, the background color of the corresponding setting value and ramp rate value of the ITEM type may be displayed to be different from that of other ITEM types.

As described above, by explicitly displaying ITEMs and steps whose control value exceeds a threshold value, it is possible to easily check a setting error.

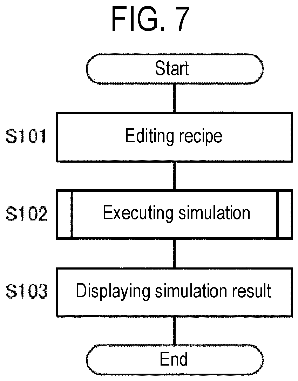

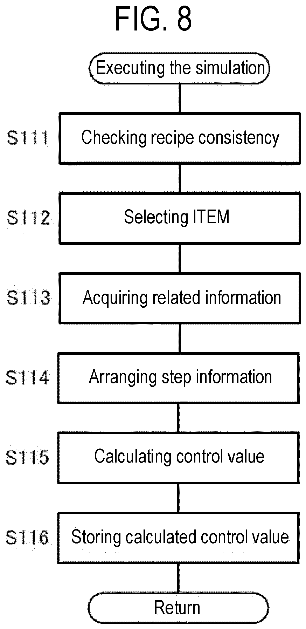

Next, an operation of the substrate processing apparatus 1 according to the embodiments of the present disclosure will be described with reference to FIGS. 7 and 8. FIG. 7 is a flowchart showing an example of the flow of the simulation process according to the embodiments of the present disclosure. In step S101 shown in FIG. 7, the operator 203 receives, for example, a recipe editing operation via the recipe editing screen 40 shown in FIG. 4 described above. In the recipe editing operation, an editing operation is performed on at least one ITEM included in the processing condition.

In step S102, the control part 101 executes a simulation execution process that calculates a control value for a setting value of a selected ITEM in conformity with the processing condition edited in step S101. Specifically, when the Simulation button 45G on the recipe editing screen 40 shown in FIG. 4 is pressed, the simulation execution process shown in FIG. 8 is executed.

FIG. 8 is a subroutine showing an example of the flow of the simulation execution process in step S 102 shown in FIG. 7. In step S 111 shown in FIG. 8, the control part 101 checks consistency of values set for each step via the recipe editing screen 40 shown in FIG. 4.

In step S112, the displayer 204 displays, for example, the ITEM type selection screen 50 shown in FIG. 5 as a pop-up screen or a dialog screen, and the operator 203 receives selection of an ITEM to be simulated (e.g., a temperature, a gas flow rate, a pressure, a transporter, or the like) via the ITEM type selection screen 50.

In step S 113, the control part 101 acquires, as information relating to the ITEM selected in step S 112, for example, recipes (sub-recipes, alarm recipes, abort recipes, reset recipes, or the like), tables (alarm condition tables, leak check tables, or the like), various parameters, and the like.

In step S 114, the control part 101 arranges the step information of the selected ITEM. Specifically, the control part 101 arranges the step information based on information such as sub-recipes, alarm recipes, abort recipes, and reset recipes, which are called in the recipe, and jumps and repeats (loop), which are specified in the steps, such that the entire steps are arranged in a time-series order.

In step S 115, the calculator 106 calculates a control value for each step based on the setting values and ramp rate values of the ITEMs set in the respective steps arranged in a time-series order in step S 114.

In step S 116, the control part 101 stores the control value calculated for each step in step S 115 in the memory 104, and returns to step S 103 shown in FIG. 7.

Returning to FIG. 7, in step S103, the control part 101 arranges the control values for the respective steps stored in the memory 104 in a time-series order to obtain time-series data of the control values as time-series data, and causes, for example, the calculation result display screen 60 shown in FIG. 6 to display thus obtained time-series data of the control values together with the step information. Then, a series of processes are completed.

As described above, according to the embodiments of the present disclosure, regarding the control values for the respective setting values of the recipe edited during recipe editing, it is possible to check the consistency of the control values for the respective setting values without actually executing the recipe. In a case where the control values are not appropriate, a user may immediately return to the recipe editing to perform step organization such as the combination of steps constituting the recipe and the order of execution thereof, and correction of the setting values set for the steps. Since the time-series data of the control values is displayed corresponding to step information, it is possible to easily understand which step the control value corresponds to.

### <First Modification: Variable Value Setting Function>

In the embodiments of the present disclosure described above, examples are described in which the user inputs and changes the setting values and the control parameters in each step in the ITEM setting region 44 on the recipe editing screen 40. However, the present disclosure is not limited to such embodiments.

Setting values set for respective setting items of respective steps (in the following description, "setting values" may also include control parameters) may not be directly edited on the recipe editing screen 40. Values set in advance on an editing screen other than the recipe editing screen 40 and recorded in the memory 104 or the like may be applied to the setting values as predetermined setting values (default setting values). By restricting the free input and change of setting values on the recipe editing screen 40 in this way, it is possible to prevent the setting values from being erroneously changed by a user on the recipe editing screen 40.

On the other hand, in a case where the predetermined setting values may be applied on the recipe editing screen 40, the predetermined setting values may be changed each time simulation results other than the predetermined setting values are to be obtained, which may reduce a work efficiency. Therefore, in this modification (first modification), instead of making it possible to simply apply the predetermined setting values to each setting item of each step on the recipe editing screen 40, other setting values (hereinafter simply referred to as variable setting values) different from the predetermined setting values may be temporarily set to replace the predetermined setting values even on the recipe editing screen 40.

Specifically, for example, for each setting item, a predetermined setting value and one or more values (candidate values) serving as candidates for setting values are stored in advance in the memory 104. In the ITEM setting region 44, the predetermined setting value and one of the candidate values thereof. The selected predetermined setting value or the selected candidate value (i.e., variable setting value) is set for the corresponding setting item. The predetermined setting value and the variable setting value may be selected from, for example, a pull-down button provided for each setting item and configured to display a plurality of candidate values.

In addition, a display (e.g., a pull-down button, a dialog box that newly pops up, or the like) that allows a selection between setting of the predetermined setting value and setting of the variable setting value may also be performed for each setting item. In a case where a state of setting the predetermined setting value is selected, the predetermined setting value is set as the setting value. In a case where the state of setting the variable setting value is selected, one variable setting value is selected from a display such as a pull-down button that displays one or more variable setting value candidates provided for each setting item.

Candidate values for each setting item may be set on an editing screen other than the recipe editing screen 40, or may be set by reading candidate value data stored in the external memory 202. Further, for example, in the ITEM setting region 44, a numerical value inputted by a user from the input may be set as a variable setting value for a predetermined setting item.

In this modification, during an ITEM editing operation, the control part 101 performs calculation (simulation) of a control value based on the setting values including the variable setting values set instead of the predetermined setting value. Specifically, for example, when the Simulation button 45G is pressed during recipe editing, calculation of the control value for the ITEM type selected on the ITEM type selection screen 50 is executed based on the setting values including the variable setting values. For the ITEMs (setting items) for which the predetermined setting value is set, the control value is calculated based on the predetermined setting value, as in the above-described embodiments.

This makes it possible to check control values based on the setting values including the variable setting values without actually executing the recipe. Therefore, a user may easily check whether the variable setting values set during recipe editing are appropriate.

When performing this simulation calculation, even for the setting item for which variable setting values are set, a calculation may also be performed at the same time to simulate the control value based on the setting value that simply includes the predetermined setting value before being replaced with the variable setting value. As a result, on a calculation result display screen 60' which will be described later, a state in which the time-series data of control values obtained by simulation of control values based on the setting values including the variable setting values (i.e., variable setting value simulation) is displayed as a graph, and a state in which the time-series data of control values obtained by simulation of control values based on the setting values simply including the predetermined setting value (i.e., predetermined setting value simulation) is displayed as a graph, may be quickly switched, or time-series data in both the states may be displayed as a graph at the same time.

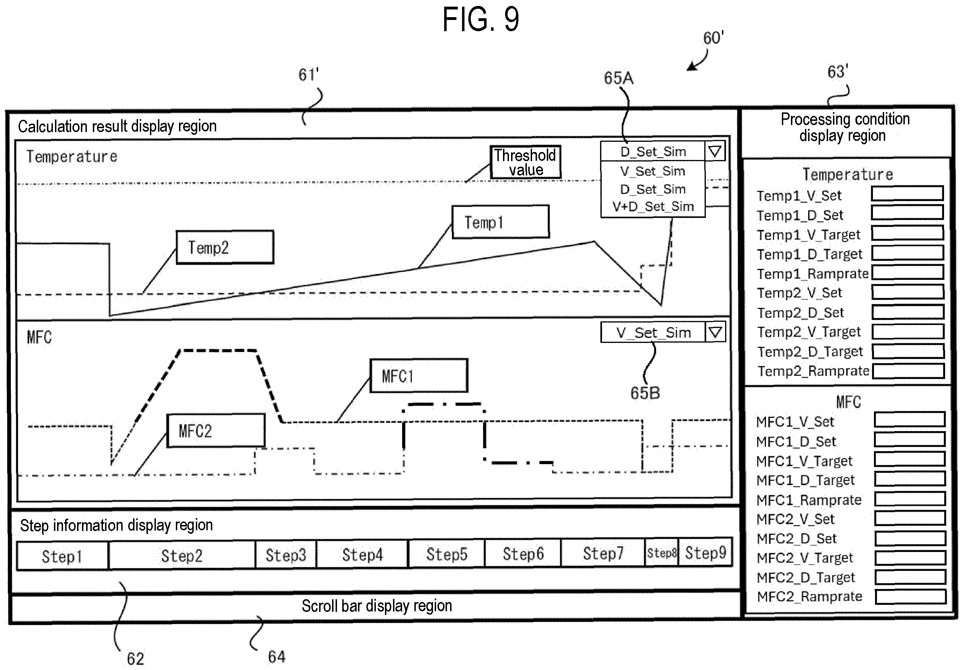

FIG. 9 is a front view showing an example of the calculation result display screen 60' according to this modification (first modification). Regarding the points other than those specifically mentioned below, the calculation result display screen 60' according to this modification is similar to the calculation result display screen 60 according to the embodiments of the present disclosure described above. When the ITEM type is selected on the ITEM type selection screen 50 and the "OK" button is pressed, the calculation result display screen 60' is displayed after the simulation calculation is executed.

The ITEM type selection screen 50 may perform display that allows selection of whether to perform a variable setting value simulation or a predetermined setting value simulation. For example, a button that allows selection of either variable setting value simulation or predetermined setting value simulation or a pull-down button may be displayed on the ITEM type selection screen 50.

After the simulation calculation is executed, the displayer 204 displays the time-series data of the control values obtained by the variable setting value simulation on the calculation result display screen 60' in conformity with the execution order of steps.

The calculation result display region 61' is another example of the first display region, and is a region configured to display the time-series data of control values obtained by the variable setting value simulation.

Further, in this modification, a state (V_Set_Sim) in which the time-series data of control values obtained through the variable setting value simulation is displayed in the calculation result display region 61', a state (D_Set_Sim) in which the time-series data of control values obtained through the predetermined setting value simulation is displayed in the same region, and a state (V+D_Set_Sim) in which both the time-series data are displayed at the same time in the same region such that they are superimposed (or in parallel on the same time axis) may be displayed in a selectable manner. For example, a button or a pull-down button configured to be capable of selecting one of the three states described above is displayed in each ITEM type region of the calculation result display region 61'. In FIG. 9, an example is shown in which a pull-down button configured to be capable of selecting one of the three states described above is displayed in each of time-series data display switching regions 65A and 65B. In FIG. 9, a region in an upper side of the calculation result display region 61' for displaying time-series data of temperatures displays the time-series data of control values obtained through the predetermined setting value simulation, and a region in a lower side of the calculation result display region 61' for displaying time-series data of gas flow rate displays the time-series data of control values obtained through the predetermined setting value simulation.

Further, in the state (V_Set_Sim) in which the time-series data of control values obtained through the variable setting value simulation is displayed in the calculation result display region 61' and the state (V+D_Set_Sim) in which both the time-series data are displayed at the same time in the same region, parts differing from the time-series data of control values obtained through the predetermined setting value simulation in the graph showing the time-series data of control values obtained through the variable setting value simulation may be displayed in a highlighted manner. Examples of the highlighted display include increasing a thickness of a line as shown in FIG. 9 and changing color of a line.

The processing condition display region 63' is another example of the third display region, and is a region configured to display the processing condition of the selected ITEM type. In this modification, instead of displaying the setting value of the temperature-related item as "Temp1_Set" in the above-described embodiments of the present disclosure, for example, the variable setting value and the predetermined setting value are displayed as "Temp1_V_Set" and "Temp1_D_Set," respectively. Similarly, instead of displaying the control value calculated by the simulation as "Temp1_Target", for example, the control values obtained in the variable setting value simulation and the predetermined setting value simulation are displayed as "Temp1_V Target" and "Temp1_D_Target," respectively. The same applies to the setting values and the control values of the ITEM relating to the gas flow rate (MFC).

### <Second Modification: Conditional Setting Value Setting Function>

Further, in other embodiments (second modification) of the present disclosure, conditional setting values (hereinafter simply referred to as condition setting values) that are automatically selected according to conditions for each setting item of each step may be temporarily set on the recipe editing screen 40 to replace the predetermined setting value. This modification is the same as the above-described modification (first modification) except for the points specifically mentioned below.

In this modification, values of condition parameters (condition parameter values) referred to when determining a condition setting value are set for the recipe to be edited. Examples of the condition parameters to be set include the number of product wafers to be processed at one time according to the recipe, the target thickness (target film thickness) of a film formed on the product wafer by a process according to the recipe, and the like. These condition parameter values may be set on a screen other than the recipe editing screen 40, or may be set via a condition parameter setting region displayed on the recipe editing screen 40.

For each setting item, a predetermined setting value and values (candidate values) serving as candidates for setting values respectively associated with a plurality of different condition parameter values (or value ranges) are stored in the memory 104 in advance. For example, when the number of product wafers is referred to as a condition parameter, condition setting value candidates are respectively associated with two value ranges such as 1 to 50 wafers for condition 1 and 51 to 100 wafers for condition 2.

In the ITEM setting region 44, for each setting item, display (e.g., a pull-down button, or the like) is performed to allow selection of either setting of a predetermined setting value or setting of a condition setting value. In a case where the state of setting the predetermined setting value is selected, the predetermined setting value is set as the setting value. In a case where the state of setting the condition setting value is selected, the condition parameter value set for the recipe is referred to, and the setting value corresponding to the condition parameter value is automatically selected as the condition setting value among the candidate values stored in the memory 104. The selected condition setting value is set for the target setting item instead of the predetermined setting value.

For example, in a case where the number of product wafers is referred to as a condition parameter when setting the condition setting value and a state of setting the condition setting value is selected for a setting item, the number of product wafers (e.g., 100) set for the recipe to be edited is referred to, and the corresponding candidate value (in the above example, the candidate value associated with condition 2, which includes 100 wafers) is set for the target setting item.

In this modification, during an ITEM editing operation, the control part 101 performs a calculation (simulation) of a control value based on the setting values including the condition setting values set instead of the predetermined setting value. Specifically, for example, when the Simulation button 45G is pressed during recipe editing, the calculation of a control value for the ITEM type selected on the ITEM type selection screen 50 is executed based on the setting values including the condition setting values.

This makes it possible to check control values based on the setting values including the condition setting values without actually executing the recipe. Therefore, during the recipe editing, a user may easily check whether the condition setting values changing according to the condition parameter values are appropriate.

When performing this calculation, a calculation that simulates the control value may be simultaneously executed based on the setting values that include candidate values other than the condition setting values set for the recipe as the condition setting values. For example, in the above example where two candidate values are associated with the number of product wafers, a calculation that simulates the control value is performed based on the setting values that include, as the condition setting value, a candidate value which is not automatically selected and corresponds to condition 1 other than the candidate value corresponding to condition 2 that matched the referred condition parameter value. As a result, on the calculation result display screen 60" to be described later, a state in which the time-series data of control values obtained through the simulation of control values based on the setting values including the condition setting values corresponding to condition 1 (i.e., condition setting value simulation for condition 1) is displayed as a graph, and a state in which the time-series data of control values obtained through the simulation of control values based on the setting values including the condition setting values corresponding to condition 2 (i.e., condition setting value simulation for condition 2) is displayed as a graph, may be quickly switched, or both the time-series data may be displayed as a graph at the same time.

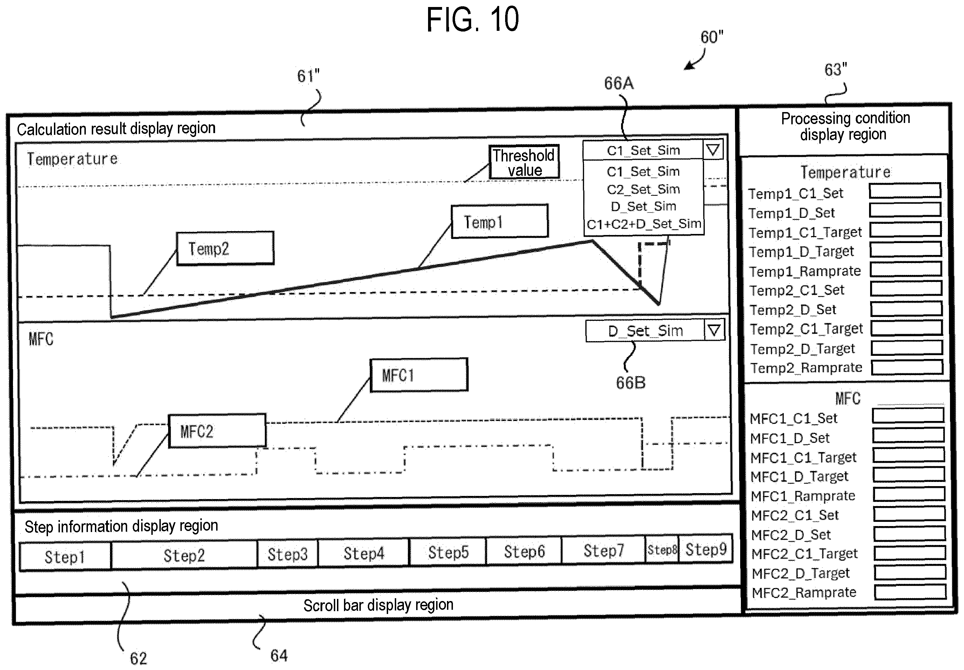

FIG. 10 is a front view showing an example of the calculation result display screen 60" according to this modification (second modification). When the ITEM type is selected on the ITEM type selection screen 50 and the "OK" button is pressed, the calculation result display screen 60' is displayed after the simulation calculation is executed. As in the first modification, the ITEM type selection screen 50 may perform a display that allows selection of whether to perform a condition setting value simulation or a predetermined setting value simulation.

After the simulation calculation is executed, the displayer 204 displays the time-series data of control values obtained by the condition setting value simulation on the calculation result display screen 60" in conformity with the execution order of steps. The calculation result display region 61" is another example of the first display region, and is a region configured to display the time-series data of control values obtained by the variable setting value simulation.

Further, in this modification, a state (C1_Set_Sim) in which the time-series data of control values obtained through the condition setting value simulation for condition 1 is displayed in the calculation result display region 61", a state (C2_Set_Sim) in which the time-series data of control values obtained through the condition setting value simulation for condition 2 is displayed in the same region, a state (D_Set Sim) in which the time-series data of control values obtained through the predetermined setting value simulation is displayed in the same region, and a state (C1+C2+D_Set_Sim) in which three kinds of time-series data mentioned above are displayed at the same time to be superimposed in the same region (or displayed in parallel on the same time axis), may be displayed in a selectable manner. For example, a button or a pull-down button that allows selection of one of the four types of states described above may be displayed in each region of the calculation result display region 61" for each ITEM type. In FIG. 10, an example is shown in which a pull-down button configured to allow selection of one of the four types of states described above is displayed in each of the time-series data display switching regions 66A and 66B. In FIG. 10, a region in an upper side of the calculation result display region 61" for displaying the time-series data of temperatures displays the time-series data of control values obtained through the condition setting value simulation for condition 1, and a region in a lower side of the calculation result display region 61" for displaying the time-series data of gas flow rates displays the time-series data of control values obtained through the predetermined setting value simulation. In addition to the above-mentioned combinations, an arbitrary combination of the above-mentioned three types of time-series data may be simultaneously displayed in the calculation result display region 61".

In addition, in the state in which the time-series data of control values obtained through the condition setting value simulation is displayed in the calculation result display region 61", as in the first modification, parts differing from the time-series data of control values obtained through the predetermined setting value simulation in the graph showing the time-series data of control values obtained through the condition setting value simulation may be displayed in a highlighted manner.

The processing condition display region 63" is another example of the third display region, and is a region configured to display the processing condition of the selected ITEM type. In this modification, as the setting values for the ITEM relating to the temperature, for example, the condition setting value and the predetermined setting value set on the recipe editing screen 40 are displayed as "Temp1_C1_Set" and "Temp1_D_Set", respectively. Similarly, for example, the control values obtained through the condition setting value simulation and the predetermined setting value simulation are displayed as "Temp1_C1_Target" and "Temp1_D_Target", respectively. The same applies to the setting values and the control values of the ITEM relating to the gas flow rate (MFC).

### <Other Embodiments of the Present Disclosure>

The substrate processing apparatus according to the embodiments of the present disclosure are described above by way of example. The embodiments may be in the form of programs that causes a computer to execute functions of the substrate processing apparatus. The embodiments may be in the form of a computer-readable non-transitory recording medium storing these programs.

Further, the configuration of the substrate processing apparatus described in the aforementioned embodiments is an example, and may be changed according to the situation without departing from the spirit of the present disclosure.

Further, the process flow of the program described in the aforementioned embodiments is an example. Some steps may be deleted, new steps may be added, or the process order may be changed without departing from the spirit of the present disclosure.

Further, in the above-described embodiments, cases are described in which the process according to the embodiments is realized by a software configuration by using a computer by executing programs. However, the present disclosure is not limited thereto. The embodiments may be realized by, for example, a hardware configuration or a combination of a hardware configuration and a software configuration.

In the above-described embodiments, examples are described in which a film is formed by using a batch-type substrate processing apparatus configured to process a plurality of substrates at a time. The present disclosure is not limited to the above-described embodiments, and may be suitably applied, for example, to a case where a film is formed by using a single-wafer-type substrate processing apparatus configured to process one or several substrates at a time. Further, in the above-described embodiments, examples are described in which a film is formed by using the substrate processing apparatus including a hot-wall-type process furnace. The present disclosure is not limited to the above-described embodiments, and may be suitably applied to a case where a film is formed by using a substrate processing apparatus including a cold-wall-type process furnace.

Even when using these substrate processing apparatuses, each process may be performed under the same processing procedure and processing conditions as in the above-described embodiments, and the same effects as in the above-described embodiments may be obtained.

According to the present disclosure in some embodiments, it is possible to improve a work efficiency when editing a recipe.

While certain embodiments are described above, these embodiments are presented by way of example, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A substrate processing apparatus (1), comprising:
a substrate processor configured to process a substrate (18) according to a recipe including at least one step defining a substrate processing condition;
an operator (203) configured to receive an editing operation for at least one setting item included in the substrate processing condition;
a calculator (106) configured to calculate a control value for a setting value of the at least one setting item in conformity with an edited substrate processing condition obtained by the editing operation; and
a controller (100) configured to be capable of controlling a displayer (204) to display time-series data of the control value calculated by the calculator (106) together with information about the at least one step.

2. The substrate processing apparatus (1) of Claim 1, wherein the operator (203) is configured to instruct the controller (100) to calculate the control value during the editing operation for the at least one setting item.

3. The substrate processing apparatus (1) of Claim 1, wherein the operator (203) is configured to receive a selection of type information for which the control value is calculated.

4. The substrate processing apparatus (1) of Claim 1, wherein the calculator (106) is configured to change an execution order of the at least one step from an execution order set in the recipe in conformity with an actual operation of processing the substrate (18).

5. The substrate processing apparatus (1) of Claim 1, wherein the displayer (204) includes a screen (60) configured to display the time-series data of the control value, and
wherein the displayer (204) is configured to display the time-series data of the control value on the screen (60) in conformity with an execution order of the at least one step.

6. The substrate processing apparatus (1) of Claim 5, wherein the screen (60) includes at least one selected from the group of a first display region (61, 61', 61") configured to display the time-series data of the control value, a second display region (62) configured to display the information about the at least one step in conformity with the execution order, and a third display region (63, 63', 63") configured to display the substrate processing condition.

7. The substrate processing apparatus (1) of Claim 1, wherein the displayer (204) is configured to display the time-series data of the control value in conjunction with a recipe execution result obtained by processing the substrate (18) according to the recipe such that the time-series data of the control value is capable of being compared with the recipe execution result.

8. The substrate processing apparatus (1) of Claim 1, wherein the displayer (204) is configured to display the time-series data of the control value and state information indicating a state of at least one selected from the group of a gas pipe and a valve side by side, and display time-series data of a control value for a designated step among the at least one step and the state information on one screen (60).

9. The substrate processing apparatus (1) of Claim 1, further comprising:
a determinator (107) configured to determine whether the control value is correct or not,
wherein the determinator (107) determines whether the control value is correct or not for each of the at least one setting item of the recipe according to a predetermined determination condition.

10. The substrate processing apparatus (1) of Claim 1, wherein, in the editing operation received by the operator (203), either a predetermined setting value or a variable setting value different from the predetermined setting value is capable of being set as the setting value for the at least one setting item, and
wherein the calculator (106) is configured to calculate a control value for the variable setting value when the variable setting value is set for the at least one setting item.

11. The substrate processing apparatus (1) of Claim 10, wherein the calculator (106) is configured to calculate a control value for the predetermined setting value and the control value for the variable setting value when the variable setting value is set for the at least one setting item, and
wherein the controller (100) is configured to cause the displayer (204) to simultaneously or selectively display time-series data of the control value for the predetermined setting value and time-series data of the control value for the variable setting value together with the information about the at least one step.

12. The substrate processing apparatus (1) of Claim 1, wherein, in the editing operation received by the operator (203), either a predetermined setting value or a conditional setting value selected according to a value of a condition parameter set in the recipe is capable of being set as the setting value for the at least one setting item, and
wherein the calculator (106) is configured to calculate a control value for the conditional setting value when the conditional setting value is set for the at least one setting item.

13. The substrate processing apparatus (1) of Claim 12, wherein the calculator (106) is configured to calculate a control value for the predetermined setting value and the control value for the conditional setting value when the conditional setting value is set for the at least one setting item, and
wherein the controller (100) is configured to cause the displayer (204) to simultaneously or selectively display time-series data of the control value for the predetermined setting value and time-series data of the control value for the conditional setting value together with the information about the at least one step.

14. A method of manufacturing a semiconductor device, comprising:
processing a substrate (18) according to a recipe including at least one step defining a substrate processing condition;
performing an editing operation for a setting item in the substrate processing condition;
calculating a control value for a setting value of the setting item in conformity with an edited substrate processing condition obtained by the editing operation; and
controlling a displayer (204) to display time-series data of the calculated control value together with information about the at least one step.

15. A program that causes, by a computer, a substrate processing apparatus (1) to perform:
processing a substrate (18) according to a recipe including at least one step defining a substrate processing condition;
performing an editing operation for a setting item in the substrate processing condition;
calculating a control value for a setting value of the setting item in conformity with an edited substrate processing condition obtained by the editing operation; and
controlling a displayer (204) to display time-series data of the calculated control value together with information about the at least one step.
